**Europäisches Patentamt**

**European Patent Office**

**Office européen des brevets**

(19)

(11) Veröffentlichungsnummer : **0 099 040**
B1

(12)

# EUROPÄISCHE PATENTSCHRIFT

(45) Veröffentlichungstag der Patentschrift :
01.02.89

(51) Int. Cl.⁴ : **H 03 H   7/01**, H 03 H   7/12, H 04 N   9/70

(21) Anmeldenummer : 83106478.7

(22) Anmeldetag : 02.07.83

(54) **Filter mit Umschaltbarer Bandbreite.**

(30) Priorität : 13.07.82 DE 3226143

(43) Veröffentlichungstag der Anmeldung :
25.01.84 Patentblatt 84/04

(45) Bekanntmachung des Hinweises auf die Patenterteilung : 01.02.89 Patentblatt 89/05

(84) Benannte Vertragsstaaten :
AT DE FR GB IT

(56) Entgegenhaltungen :
US—A— 3 577 152
US—A— 4 271 529
PATENTS ABSTRACTS OF JAPAN, Band 3, Nr. 110 (E-137), 14. September 1979, Seite 151 E 137; & JP - A - 54 87 456 (SONY K.K.) 11-07-1979

(73) Patentinhaber : GRUNDIG E.M.V. Elektro-Mechanische Versuchsanstalt Max Grundig holländ. Stiftung & Co. KG.
Kurgartenstrasse 37
D-8510 Fürth/Bay. (DE)

(72) Erfinder : Würl, Werner
Voltastrasse 20
D-8510 Fuerth (DE)

EP 0 099 040 B1

**EP 0 099 040 B1**

## Beschreibung

Die Erfindung bezieht sich auf ein Filter mit umschaltbarer Bandbreite gemäß dem Oberbegriff des Anspruchs 1.

In der Nachrichtentechnik treten häufig Selektionsprobleme auf, die eine von der Betriebsart abhängige Bandbreite erfordern. So ist beispielsweise bei einem Videorecorder mit Color-Under-Farbaufzeichnung die Luminanzbreite bei Farb- und Schwarz/Weiß-Aufzeichnung unterschiedlich. Bisher wurden in diesem Fällen zwei getrennt aufgebaute Filter eingesetzt. Ferner sind umschaltbare Filter (umschaltbare Induktivitäten) bekannt.

Aus der japanischen Patentanmeldung No. 52-155419 ist ein Bandpaßfilter bekannt, dessen Durchlaßfrequenzbereich und Durchlaßbandbreite umschaltbar sind. Die Umschaltung erfolgt unter Verwendung von Schaltdioden, an deren Kathoden eine Steuerspannung derart angelegt wird, daß die Schaltdioden vom gesperrten in den leitenden Zustand bzw. umgekehrt übergeführt werden. Die genannten Schaltdioden sind mit ihrer Anode an den Mittelanschluß zwischen zwei in Reihe geschalteten Induktivitäten angeschlossen, welche jeweils Bestandteil eines Schwingkreises sind. Beim Übergang der Schaltdioden vom leitenden in den gesperrten Zustand bzw. umgekehrt ändert sich die Induktivität jedes Schwingkreises und damit die Selektionseigenschaften des Banpaßfilters.

Aus der US-Patentschrift US-A-3 577 152 ist ein Fernsehempfänger mit einem umschaltbaren Videoverstärker bekannt, dessen Bandbreite bei Farbempfang anders ist als bei Schwarz/Weiß-Empfang. Diese Änderung der Bandbreite erfolgt durch Veränderung der Vorspannung einer Diode, über die eine Induktivität kurzgeschlossen wird. Durch diesen Kurzschluß wird die Luminanzbandbreite reduziert.

Der Erfindung liegt die Aufgabe zugrunde, ein Filter mit umschaltbarer Bandbreite zu schaffen, das einfacher aufgebaut ist als zwei getrennte Filter oder umschaltbare Filter und ohne mechanische Schalter für die Siebkettenglieder auskommt.

Diese Aufgabe wird durch die im Anspruch 1 angegebenen Merkmale gelöst.

Vorteilhafte Weiterbildungen des erfindungsgemäßen Filters ergeben sich aus den abhängigen Ansprüchen.

Durch das erfindungsgemäße Filter mit umschaltbarer Bandbreite ist ein einfacher Aufbau gewährleistet, wodurch beispielsweise eine Bandbreitenumschaltung zwischen normalzeiligem und hochzeiligem Betrieb in einem Drop-out-Kompensator ohne großen Schaltungsaufwand ermöglicht wird. Durch den besonders einfachen Aufbau mit sehr geringem Bauteileaufwand und der Umschaltung mittels Dioden wird lediglich ein Umschalter für den gewünschten Filterbereich (Grenzfrequenz $f_{B1}$ oder $f_{B2}$) benötigt. Ferner ist eine einfache Realisierung von Hochpässen, Bandpässen und Bandsperren mit umschaltbarer Bandbreite möglich. Darüber hinaus läßt sich die Umschaltung auf die gewünschte Grenzfrequenz bzw. den gewünschten Bandbreiten-Bereich einfach auch aus großer Entfernung erreichen.

Ein Ausführungsbeispiel der Erfindung wird im folgenden unter Bezugnahme auf die Zeichnungsfigur beispielsweise näher erläutert.

Gemäß der Zeichnungsfigur, die ein Filter mit umschaltbarer Bandbreite am Beispiel eines Cauer-Tiefpasses n-ter Ordnung zeigt, sind Kondensatoren C2, C4, ... C(n-1) und Induktivitäten L21, L41, ... L(n-1)1 als Parallelschwingungskreise in den Längszweigen und Kondensatoren C1, C3, C5, ... C(n-2), Cn in den Querzweigen der Siebkette des Filters vorgesehen. Die Endanschlüsse A, B der Induktivitäten L21, L41, ... L(n-1)1 sind dabei jeweils mit dem nachfolgenden Siebkettenglied bzw. über eine Diode D2, D4, ... D(n-1) mit dem vorausgehenden Siebkettenglied verbunden. Eine antiparallel zu den ersten Dioden D2, D4, ... D(n-1) geschaltetez weitere Diode D1, D3, ... D(n-2) ist mit ihrer einen Elektrode mit einem Abgriff M der jeweils zugeordneten Induktivität L21, L41, ... L(n-1)1 verschaltet. Durch den Abgriff M an den Induktivitäten bzw. Spulen L21, L41, ... L(n-1)1 entstehen jeweils « Teil-Spulen » L22, L42, ... L(n-1)2 zwischen den Endanschlüssen A und den Abgriffen M.

Generatorseitig und ausgangsseitig sind jeweils eine Parallelschaltung aus einem Abschlußwiderstand $R_{B1}$ und einem Parallelwiderstand $R_P$ in Serie mit einer Diode D für die Grenzfrequenz $f_{B2}$ vorgesehen. Die Parallelschaltung am Ausgang des filters ist dabei entweder über eine Schalterstellung S1 eines Schalters S mit Masse oder über eine Schalterstellung S2 mit einer Betriebsspannung $+ U_B$ verbunden. Durch den erfindungsgemäßen Filteraufbau entsteht dabei ein unterschiedlicher Spannungsweg bzw. ein unterschiedliches Spannungsgefälle für eine erste ($f_{B1}$) oder zweite ($f_{B2}$) Grenzfrequenz durch ein bezüglich der maximalen bzw. minimalen Betriebsspannung des Generators G höheres bzw. niedrigeres Potential.

Der Generator G weist vorzugsweise einen Innenwiderstand $R_i$ von ca. $0\Omega$ und einen Gleichspannungsanteil der halben Betriebsspannung ($U_{B/2}$) auf.

Eine (nicht dargestellte) Schaltungsvariante für den generatorseitigen Anschlußbereich sieht beispielsweise die Verbindung der Parallelschaltung (Widerstand $R_{B1}$ mit Widerstand $R_P$ und Diode D) mit einer Emitterfolgerschaltung mit zwei komplementären Transistoren vor, deren Emitter verbunden sind und deren Emitterspannung die Hälfte der Betriebsspannung, d. h. $U_{B/2}$ beträgt. Für den ausgangsseitigen Bereich kann an die Parallelschaltung aus dem Widerstand $R_{B1}$ und dem Widerstand $R_P$ mit der Diode D ein Komparator mit einem Widerstand $R_A$ von ca. $0\Omega$ bekannten Aufbaus verschaltet sein, wobei der Komparator eine Ausgangsspannung aufweist, die abhängig vom Eingangssignal der Betriebsspannung $U_B$ oder 0 Volt entspricht.

Im folgenden wird eine Dimensionierungsvorschrift für den Aufbau der einzelnen Elemente des erfindungsgemäßen Filters mit umschaltbarer Bandbreite beschrieben:

Die Bauteile eines Filters (Cauer, Tschebyscheff oder Butterworth-Filter) errechnen sich aus den normierten Werten folgendermaßen:

$$Cn = Cv \cdot C_B$$

$$Ln = Lv \cdot L_B,$$

wobei Cv die normierten Kapazitäten und Lv die normierten Induktivitäten darstellt.

Es gilt ferner

$$CB = \frac{1}{2 \times \pi \times f_B \times R_B} \; ; \quad L_B = \frac{R_B}{2 \times \pi \times f_B},$$

wobei $R_B$ den Abschlußwiderstand und $f_B$ die Grenzfrequenz des Durchlaßbereichs darstellt.

Da sich umschaltbare Induktivitäten und umschaltbare Abschlußwiderstände, wie noch dargelegt werden wird, leicht realisieren lassen, werden die Kapazitäten des Filters mit der Grenzfrequenz $f_{B1}$ auch beim Filter mit der Grenzfrequenz $f_{B2}$ verwendet. Daraus folgt: $C_{B1} = C_{B2}$.

Zur Vereinfachung der Gleichung setzt man:

$$f_{B2} = n \times f_{B1},$$

wobei n eine beliebige reelle Zahl größer 1 darstellt, die angibt, wie sich die beiden Grenzfrequenzen zueinander verhalten.

Die Bedingung $C_{B1} = C_{B2}$ ist nur zu erfüllen, wenn sich der Abschlußwiderstand $R_{B2}$ für das Filter mit der Grenzfrequenz $f_{B2}$ gegenüber dem Abschlußwiderstand $R_{B1}$ des Filters mit der Grenzfrequenz $f_{B1}$ wie folgt ändert:

$$C_{B1} = \frac{1}{2 \times \pi \times f_{B1} \times R_{B1}} = C_{B2} = \frac{1}{2 \times \pi \times n \times f_{B1} \times \left( \dfrac{R_{B1}}{n} \right)},$$

wobei die Dimensionierungsvorschrift für den Abschlußwiderstand $R_{B2}$ lautet:

$$R_{B2} = \frac{R_{B1}}{n}.$$

Die Induktivität $L_{B2}$ des Filters mit der Grenzfrequenz $f_{B2} = n \times f_{B1}$ errechnet sich zu:

$$L_{B2} = \frac{\dfrac{R_{B1}}{n}}{2 \times \pi \times f_{B1} \times n} = \frac{1}{n^2} \left( \frac{R_{B1}}{2 \times \pi \times f_{B1}} \right) = \frac{L_{B1}}{n^2},$$

wobei der Klammerausdruck der Induktivität $L_{B1}$ entspricht.

Da sich die tatsächliche Induktivität zu $L_n = L_B \times L_v$ errechnet und $L_v$ für beide Filter gleich ist, gilt

$$L_{n2} = \frac{L_{n1}}{n^2}.$$

Eine Spule mit umschaltbarer Induktivität ist einfach durch eine Spule mit angezapfter Wicklung zu realisieren: Durch den Abgriff M entstehen mit den Spulenenden A bzw. B « Teil-Spulen » mit Windungszahlen $m_1$ bzw. $m_2$. Daraus folgt

$$L_{n1} = L_{(\overline{AB})}$$

bzw.

$$L_{n2} = L_{(\overline{AM})}.$$

Unter Berücksichtigung der Windungszahlen ergibt sich :

$$L_{n1} = k \times (m_1 + m_2)^2 \qquad \text{(I)}$$

und

$$L_{n2} = k \times m_1^2 = \frac{L_{n1}}{n^2}, \qquad \text{(II)}$$

wobei k die Spulenkonstante darstellt.

Durch Division der Gleichungen (I) und (II) ergibt sich

$$1 = \frac{(m_1 + m_2)^2}{n^2 \times m_1^2} ;$$
$$n \times m_1 = m_1 + m_2 ;$$
$$m_2 = m_1(n-1),$$

d. h. die Dimensionierungsvorschrift für die Induktivität(en) des Filters.

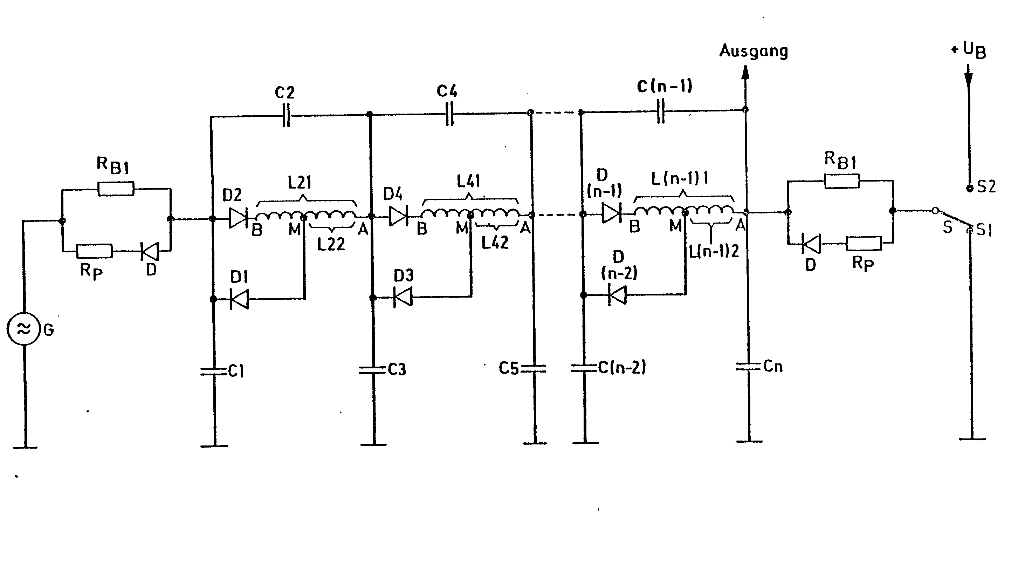

## Patentansprüche

1. Aus mindestens einem Teilfilter gebildetes Filter mit umschaltbarer Bandbreite mit jeweils im Längs- und Querzweig liegenden Reaktanzelementen (C1, C3, ... C(n-2) ; Cn/C2 ; C4 ; ...C(n-1)/L21 ; L41 ; ...L(n-1)1), bei dem im Längszweig liegende Induktivitäten jeweils einen Abgriff aufweisen und mittels Schaltdioden auf diesen umschaltbar sind, dadurch gekennzeichnet, daß

a) in jedem Teilfilter

— ein Endanschluß des Längszweiges und ein Endanschluß (B) der umschaltbaren Induktivität (L21 ; L41 ; ...L(n-1)1) mit einer Diode (D2 ; D4 ; ...D(n-1)) und

— der genannte Endanschluß des Längszweiges und der Abgriffpunkt (M) der umschaltbaren Induktivität mit einer antiparallel zu der ersten geschalteten weiteren Diode (D1 ; D3 ; ...D(n-2)) verbunden ist und daß

b) über einen Umschalter (S) ein bezüglich der maximalen bzw. minimalen Betriebsgleichspannung des Generators (G) höheres $(+ U_B)$ oder niedrigeres (Masse) Potential zur Erzeugung eines unterschiedlichen Spannungsgefälles für eine erste $(f_{B1})$ oder eine zweite $(f_{B2})$ Grenzfrequenz angelegt ist.

2. Filter nach Anspruch 1, dadurch gekennzeichnet, daß der Umschalter (S) ein elektronischer Schalter ist.

3. Filter nach einem der vorhergehenden Ansprüche, dadurch gekennzeichnet, daß generatorseitig und ausgangsseitig jeweils eine Parallelschaltung aus einem Widerstand $(R_{B1})$ für den Filterbereich mit der ersten Grenzfrequenz $(f_{B1})$ und einem Parallelwiderstand $(R_p)$ in Serie mit einer Diode (D) für die zweite Grenzfrequenz $(f_{B2})$ vorgesehen ist.

4. Filter nach Anspruch 3, dadurch gekennzeichnet, daß der Abschlußwiderstand $(R_{B2})$ für den Filterbereich mit der zweiten Grenzfrequenz $(f_{B2})$ nach der mathematischen Beziehung

$$R_{B2} = \frac{R_{B1}}{n}$$

berechnet wird, wobei $R_{B1/2}$ die Abschlußwiderstände und n eine beliebige reelle Zahl größer 1 bedeuten, die angibt, wie sich die beiden Grenzfrequenzen zueinander verhalten.

5. Filter nach Anspruch 3, dadurch gekennzeichnet, daß generatorseitig eine Emitterfolgerschaltung mit zwei komplementären Transistoren vorgesehen ist, deren Emitter verbunden sind und deren Emitterspannung die Hälfte der Betriebsspannung $(U_{B/2})$ beträgt und ausgangsseitig ein Komparator mit einer Ausgangsspannung vorgesehen ist, die abhängig vom Eingangssignal der Betriebsspannung $(U_B)$ oder 0 Volt entspricht.

## Claims

1. Filter having a switchable bandwidth and formed from at least one part filter, having reactance elements (C1, C3, ...C(n-2) ; Cn/C2 ; C4 ; ... C(n-1)/L21 ; L41 ; ...L(n-1)1), which are in each case located in the series and shunt branch, in which inductances located in the series branch in each case exhibit one tap and are switchable to this by means of switching diodes, characterized in that

a) in each part filter

— a termination of the series branch and a termination (B) of the switchable inductance (L21 ; L41 ; ... L(n-1)1) is connected to a diode (D2 ; D4 ; ... D(n-1)) and

— the said termination of the series branch and the tapping point (M) of the switchable inductance is connected to a further diode (D1 ; D3 ; ... D(n-2)), which is connected in antiparallel with the first diode, and that

b) a potential which is higher (+ $U_B$) or lower (earth) with respect to the maximum or minimum operating direct voltage of the generator (G) is applied via a change-over switch (S) for generating a different voltage gradient for a first ($f_{B1}$) or a second ($f_{B2}$) cut-off frequency.

2. Filter according to Claim 1, characterized in that the change-over switch (S) is an electronic switch.

3. Filter according to one of the preceding claims, characterized in that on the generator side and on the output side in each case a parallel circuit of a resistor ($R_{B1}$) for the filter range with the first cut-off frequency ($f_{B1}$) and a parallel resistor ($R_p$) in series with a diode (D) for the second cut-off frequency ($f_{B2}$) is provided.

4. Filter according to Claim 3, characterised in that the terminating resistance ($R_{B2}$) for the filter range with the second cut-off frequency ($f_{B2}$) is calculated in accordance with the mathematical relation where $R_{B1/2}$ means the terminating resistances and n means

$$R_{B2} = \frac{R_{B1}}{n}$$

an arbitrary real number greater than 1 which specifies the relationship between the two cut-off frequencies.

5. Filter according to Claim 3, characterized in that on the generator side an emitter follower circuit having two complementary transistors is provided, the emitters of which are joined and the emitter voltage of which is one half of the operating voltage ($U_{B/2}$) and on the output side a comparator is provided which has an output voltage which, in dependence on the input signal, corresponds to the operating voltage ($U_B$) or 0 volts.

## Revendications

1. Filtre à largeur de bande commutable, formé à partir d'au moins un filtre partiel, comportant chacun dans la branche longitudinale et la branche transversale, des éléments de réactance (C1, C3, ... C(n-2) ; Cn/C2 ; C4 ; ... C(n-1)/L21 ; L41... L(n-1)1), dans lequel les inductances situées dans la branche longitudinale présentent une prise et sont commutables au moyen de diodes de commutation sur celle-ci, caractérisé en ce que :

a) dans chaque filtre partiel

— une connexion terminale de la branche longitudinale et une connexion terminale (B) de l'inductance commutable (L21 ; L41 ; L(n-1)1) sont reliées à une diode (D2 ; D4 ; ... D(n-1)) et

— la connexion terminale citée de la branche longitudinale et le point de prise (M) de l'inductance commutable sont reliés à une autre diode (D1 ; D3 ; ... D(n-2)) montée anti-parallèle relativement à la première, et en ce que

b) par l'intermédiaire d'un commutateur (S), un potentiel supérieur (+ $U_B$) ou inférieur (masse) respectivement à la tension continue maximale et minimale de fonctionnement du générateur (G) est appliqué pour produire un gradient de tension différent pour une première fréquence limite ($f_{B1}$) ou une deuxième fréquence limite ($f_{B2}$).

2. Filtre selon la revendication 1, caractérisé en ce que le commutateur (S) est un commutateur électronique.

3. Filtre selon l'une des revendications ci-dessus, caractérisé en ce que du côté du générateur et du côté de la sortie, il est prévu un circuit parallèle constitué d'une résistance ($R_{B1}$) pour la gamme de filtre présentant la première fréquence limite ($f_{B1}$) et d'une résistance parallèle ($R_p$) montée en série avec une diode (D) pour la deuxième fréquence limite ($f_{B2}$).

4. Filtre selon la revendication 3, caractérisé en ce que la résistance terminale $R_{B2}$ pour la gamme de filtre présentant la deuxième fréquence limite ($f_{B2}$), est calculée à partir de la relation mathématique

$$R_{B2} = \frac{R_{B1}}{n}$$

$R_{B1/2}$ désignant les résistances terminales et n un nombre réel quelconque supérieur à 1 qui indique le rapport entre les deux fréquences limites.

5. Filtre selon la revendication 3, caractérisé en ce qu'il est prévu côté générateur un montage émetteur-suiveur comportant deux transistors complémentaires, dont les émetteurs sont reliés et dont la tension d'émetteur est égale à la moitié de la tension de service ($U_{B/2}$) et en ce qu'il est prévu côté sortie d'un comparateur d'une tension de sortie qui est fonction du signal d'entrée de la tension de service ($U_B$) ou égale à 0 volt.

EP 0 099 040 B1